(19) **Europäisches Patentamt / European Patent Office / Office européen des brevets**

(11) **EP 3 558 862 B1**

(12) **FASCICULE DE BREVET EUROPEEN**

(45) Date de publication et mention
de la délivrance du brevet:
**21.10.2020 Bulletin 2020/43**

(21) Numéro de dépôt: **17832289.7**

(22) Date de dépôt: **22.12.2017**

(51) Int Cl.:
**B81B 3/00** *(2006.01)* **G01P 1/00** *(2006.01)*

(86) Numéro de dépôt international:
**PCT/FR2017/053812**

(87) Numéro de publication internationale:
**WO 2018/115786 (28.06.2018 Gazette 2018/26)**

(54) **STRUCTURE MICROELECTRONIQUE A AMORTISSEMENT VISQUEUX CONTROLÉ PAR MAÎTRISE DE L'EFFET THERMO-PIEZORESISTIF**

MIKROELEKTRONISCHE STRUKTUR MIT KONTROLLIERTER VISKOSER DÄMPFUNG DURCH STEUERUNG EINES THERMO-PIEZORESISTIVEN EFFEKTS

MICROELECTRONIC STRUCTURE WITH VISCOUS DAMPING CONTROLLED BY CONTROLLING A THERMO-PIEZORESISTIVE EFFECT

(84) Etats contractants désignés:
**AL AT BE BG CH CY CZ DE DK EE ES FI FR GB GR HR HU IE IS IT LI LT LU LV MC MK MT NL NO PL PT RO RS SE SI SK SM TR**

(30) Priorité: **22.12.2016 FR 1663255**

(43) Date de publication de la demande:
**30.10.2019 Bulletin 2019/44**

(73) Titulaires:
• **Commissariat à l'énergie atomique et aux énergies alternatives**
**75015 Paris (FR)**
• **Safran Electronics & Defense**
**92100 Boulogne-Billancourt (FR)**

(72) Inventeurs:
• **JOURDAN, Guillaume**
**38000 Grenoble (FR)**
• **LEHEE, Guillaume**
**92100 Boulogne Billancourt (FR)**

(74) Mandataire: **Brevalex**
**95, rue d'Amsterdam**
**75378 Paris Cedex 8 (FR)**

(56) Documents cités:
• **GUILLAUME LEHÉE ET AL: "Low power damping control of a resonant sensor using back action in silicon nanowires", IEEE XPLORE DIGITAL LIBRARY, 29 février 2016 (2016-02-29), pages 99-102, XP055401408, 2016 IEEE 29th International Conference on MEMS, Shanghai 24-28 January 2016 ISBN: 978-1-5090-1973-1 cité dans la demande**
• **AMIR RAHAFROOZ ET AL: "Fully micromechanical piezo-thermal oscillators", 2010 IEEE INTERNATIONAL ELECTRON DEVICES MEETING (IEDM 2010) : SAN FRANCISCO, CALIFORNIA, USA, 6 - 8 DECEMBER 2010, IEEE, PISCATAWAY, NJ, 6 décembre 2010 (2010-12-06), pages 7.2.1-7.2.4, XP031884927, DOI: 10.1109/IEDM.2010.5703314 ISBN: 978-1-4424-7418-5**

**Description**

## DOMAINE TECHNIQUE ET ÉTAT DE LA TECHNIQUE ANTÉRIEURE

La présente invention se rapporte à des structures microélectromécaniques et des structures nanoélectromécaniques à amortissement visqueux contrôlé par maîtrise de l'effet thermo-piézorésistif.

Les systèmes microélectromécaniques ou MEMS (Microelectromechanical system en terminologie anglo-saxonne) et les structures nanoélectromécaniques ou NEMS (Nanoelectromechanical system en terminologie anglo-saxonne) comportent une partie fixe et au moins une masse mobile par rapport à un substrat apte à être mise en vibration sous l'effet d'un stimulus extérieur, formant un résonateur.

Un résonateur ou oscillateur mécanique disposé dans un environnement gazeux subit un amortissement dû aux frottements avec le gaz lors du déplacement de la masse mobile, dit amortissement visqueux.

Le contrôle des processus d'amortissement ou de dissipation d'énergie mécanique dans un résonateur permettent d'augmenter la bande passante des MEMS et NEMS en réduisant l'intervalle de temps nécessaire pour retrouver l'équilibre avec le milieu extérieur. Plus généralement, le contrôle de la bande passante d'un résonateur mécanique peut être exploité pour réaliser des filtres de bande passante accordable. Enfin, la compensation des forces d'amortissement visqueux, via un tel contrôle, peut conduire le système en auto-oscillation. Cette propriété peut être exploitée pour réaliser des oscillateurs électromécaniques

Le contrôle de l'amortissement visqueux constitue un moyen efficace pour modifier la réponse électromécanique d'une structure MEMS/NEMS : le comportement mécanique d'un microsystème soumis à un stimulus extérieur peut être profondément redéfini que ce soit en termes de temps de réponse pour atteindre son régime stationnaire, de sensibilité à des perturbations proches de la fréquence de résonance, ou de capacité à réaliser un système auto-oscillant.

Plusieurs solutions existent pour modifier cet amortissement visqueux auquel est soumis le résonateur.

En effet, les modes de vibrations qui mettent en œuvre des mouvements en interaction avec des lames d'air sont dominés par des processus d'amortissement pneumatiques lorsqu'ils sont placés sous air : par exemple des poutres en flexion, des masses en translation. Au voisinage de la pression ambiante, la dissipation est très sensible au niveau de pression. En revanche à basse pression, avec la raréfaction des molécules, le coefficient de dissipation évolue peu. Le facteur de qualité d'un MEMS peut être ainsi contrôlé par le niveau de pression dans une cavité dans laquelle se trouve l'élément mobile, obtenu par exemple par scellement hermétique.

Par ailleurs, elle ne permet pas de contrôler indépendamment deux structures MEMS placées dans des cavités identiques. Par exemple, on peut souhaiter co-intégrer un dispositif qui nécessite un faible facteur de qualité, par exemple un accéléromètre, et un autre dispositif qui au contraire a besoin d'un facteur de qualité élevé, par exemple un gyromètre. En abaissant la pression dans la cavité, on influence les deux facteurs de qualité.

En outre, la dissipation par des processus d'amortissement pneumatiques peut être rendue négligeable lorsque le composant est placé sous un vide inférieur à 10 $\mu$bar. Elle ne peut en aucun cas compenser d'autres processus de dissipation tels que ceux qui résultent des processus thermoélastiques dans les solides. Il n'est pas possible par ce biais d'amener le système en régime d'auto-oscillation.

Une autre solution consiste à réaliser un contrôle actif du processus d'amortissement dans un MEMS. Pour cela, une force d'amortissement visqueux externe est générée. Une telle force est générée au moyen d'un actionneur contrôlable, via une électronique, dont la commande est proportionnelle à la vitesse du système mécanique mobile. Par exemple, ceci peut être réalisé en utilisant des moyens de détection du mouvement du MEMS/NEMS, un correcteur PID (proportionnel, intégral, dérivateur) et un actionneur, l'ensemble formant une boucle fermée. Cette solution est par exemple décrite dans le document *Yüceta$\int$ M, Aaltonen L, Pulkkinen M, Salomaa J, Kalanti A, Halonen K. A charge balancing accelerometer interface with electrostatic damping. In: ESSCIRC (ESSCIRC), 2011 Proceedings of the. 2011. p. 291-4.* Un système mettant en œuvre des moyens de détection et d'actionnement de type capacitif sont décrits. Bien que très efficace, cette solution nécessite la mise en œuvre d'une électronique externe au système mécanique ainsi que de moyens de détection du mouvement du MEMS/NEMS. Il en résulte un encombrement important au niveau de l'électronique et une consommation énergétique élevée, ce qui limite l'emploi de cette configuration.

Le document Lehee G, Souchon F, Riou JC, Bosseboeuf A, Jourdan G. "Low power damping control of a resonant sensor using back action in silicon nanowires". In: 2016 IEEE 29th International Conference on Micro Electro Mechanical Systems (MEMS). 2016. p.99-102 décrit une solution utilisant le phénomène d'action en retour ou effet thermo-piézorésistif dans un élément piézorésistif, également désigné par TPBA (Thermo piezoresistive Back action en terminologie anglo-saxonne). Il décrit un oscillateur comportant une masse mobile apte à osciller en rotation dans le plan et des nanojauges formées par des nanopoutres entre la masse et le substrat. Différentes positions des nanopoutres par rapport à l'axe du pivot sont testées. Les nanojauges subissent une compression ou une traction lors du déplacement de la masse. Les nanopoutres sont en silicium dopé au bore. Elles sont en matériau piézorésistif et thermoélastique.

**EP 3 558 862 B1**

Les nanopoutres sont polarisées électriquement par un courant continu, elles subissent un auto-échauffement $\Delta T = R_{th}P_j$ (I) qui est proportionnel à la puissance Joule $P_j = RI^2$ avec $R_{th}$ la résistance thermique de la poutre et $R$ la résistance électrique de la poutre.

Du fait de l'oscillation de la masse, les nanopoutres de longueur L subissent une élongation $x$ de longueur $L$.

Cette élongation provoque une modification de la résistance électrique de la poutre par piézorésistivité :

$$\delta R = \pi_g R \frac{x}{L}.$$

La puissance Joule est modifiée selon $\delta P = \delta R I^2$.

La température des poutres évolue vers une nouvelle valeur, soit une variation de $\delta T = R_{th}I^2\delta R$ (II).

Ceci aboutit à un effort mécanique en retour produit par thermoélasticité : $F = E\alpha\delta T$ avec $E$ le module d'Young du matériau composant les nanopoutres, et $\alpha$ son coefficient de dilatation thermique.

Au final, une force proportionnelle au mouvement de la structure MEMS s'applique sur cette dernière :

$$F = E\alpha R_{th}I^2\pi_g R \frac{x}{L}$$

Un effet de retard peut être induit par la résistance et l'inertie thermique des nanopoutres.

En effet une constante de temps thermique $\tau_{th} = R_{th}C_{th}$ apparaît en raison des limites de flux d'énergie thermique entre le système et l'extérieur. Cette constante de temps peut être vue comme un retard à la mise en place d'une nouvelle valeur de température. La variation de température peut être décrite par :

$$\delta T = R_{th}I^2\delta R(t - \tau_{th}) \sim R_{th}I^2\big(\delta R - \tau_{th}\delta\dot{R}\big)$$

$$F = E\alpha R_{th}I^2\pi_g R \left(\frac{x}{L} - \tau_{th}\frac{\dot{x}}{L}\right)$$

La force en retour produite par le système de mesure comporte alors un terme visqueux :

$$F_v = -\Gamma_{BA}\dot{x}$$

Avec

$$\Gamma_{BA} = \frac{\tau_{th}E\alpha R_{th}I^2\pi_g R}{L}.$$

Une modélisation plus approfondie du problème montre que la réponse harmonique de la force a en réalité la forme :

$$F(\omega) = E\alpha R_{th}I^2\pi_g R \frac{x - j\tau_{th}\dot{x}}{1 + (\omega\tau_{th})^2} \text{ (III).}$$

La force de dissipation joue un rôle important au voisinage de la fréquence de résonance $\omega_r$ du système mécanique MEMS/NEMS. L'effet sera ainsi maximal lorsque la constante de temps atteindra une valeur telle que :

$$\tau_{th}\omega_r \sim 1$$

En effet, les cas limites suivants montrent :

$\tau_{th}\omega_r$ << 1, le système adopte une température qui dépend instantanément de la position du MEMS /NEMS à l'échelle de la période d'oscillation.

$\tau_{th}\omega_r$ >> 1, la modulation de puissance due au mouvement produit une faible modulation de température de la structure TPBA améliorée. A l'échelle de la période d'oscillation, la quantité d'énergie thermique échangée entre la poutre TPBA et le circuit électrique est fortement réduite : la faible modulation de température génère une force thermoélastique de faible intensité.

On obtient une boucle de rétroaction thermo-piézorésistive.

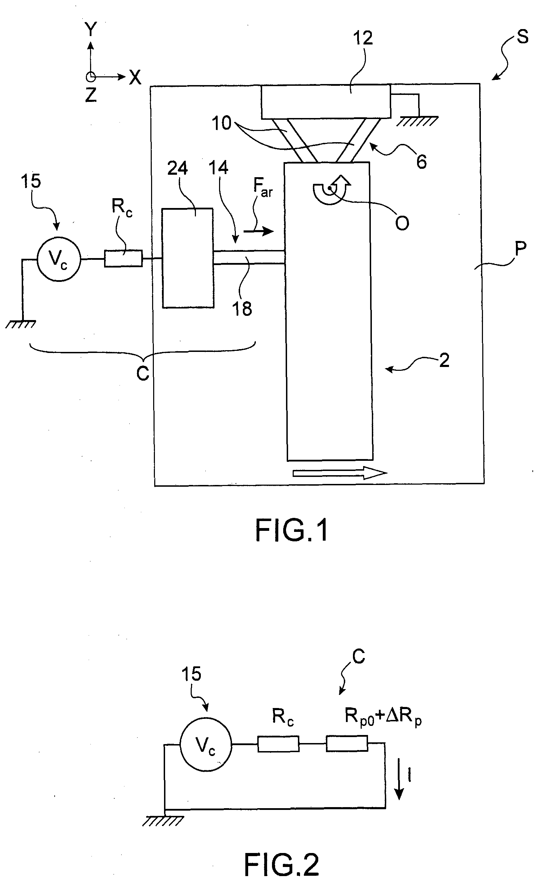

Une boucle de rétroaction thermo-piézorésistive correspond au mécanisme physique mis en jeu dans l'effet thermo-piézorésistif décrite de manière séquentielle. La figure 2 du document Lehee G, Souchon F, Riou JC, Bosseboeuf A, Jourdan G. "Low power damping control of a resonant sensor using back action in silicon nanowires". In: 2016 IEEE 29th International Conference on Micro Electro Mechanical Systems (MEMS). 2016. p.99-102 cité ci-dessus, fournit une illustration de cette boucle. Une sollicitation mécanique imposée à un élément mécanique qui est le siège d'un effet thermo-piézorésistif modifie la valeur de sa résistance électrique d'une quantité ΔR. La puissance joule dissipée dans cet élément, proportionnelle à la résistance et au niveau de polarisation électrique imposé sur celui-ci, augmente, ce qui a pour conséquence d'élever la température produite par auto échauffement Joule. Une force thermo-élastique est au final produite par l'élément mécanique en raison de cette variation de température. Ceci constitue une boucle de rétroaction, car la force obtenue correspond à une réponse mécanique que l'on obtient en retour d'une sollicitation mécanique imposée au départ du processus.

Le phénomène de TPBA offre un moyen de contrôle du facteur de dissipation simple du point de vue de l'électronique de contrôle. Pour fonctionner, le système ne requiert pas de chaine de conditionnement du signal pour la poutre piézorésistive, ni d'une électronique de contrôle pour mettre en forme un signal d'actionnement : la rétroaction a lieu localement et est auto-induit.

Par ailleurs, un tel mécanisme se révèle efficace pour contrôler le facteur d'amortissement de structure MEMS fonctionnant sous vide avec une faible consommation énergétique à quelques centaines de microwatt et sur plusieurs ordres de grandeur. En pratique, l'intensité du phénomène peut être contrôlée par le niveau de polarisation imposée à la poutre piézorésistive, ce qui offre un moyen simple pour réaliser un contrôle actif du facteur de dissipation pour une structure d'architecture donnée.

La boucle de rétroaction thermo piézorésistive décrite ici ne permet pas de contrôler aisément le signe de la rétroaction.

En effet, l'expression (III) montre que le signe de la rétroaction dépend du coefficient piézorésistif $\pi_g$ ou du coefficient de dilatation $\alpha$. Ces coefficients résultent des propriétés intrinsèques du matériau et ne peuvent être contrôlés de manière active ou en choisissant une structure particulière.

Ainsi il est admis qu'un dopage de type n est nécessaire pour obtenir une réduction du coefficient de dissipation d'un résonateur et notamment pour réaliser un auto-oscillateur à une fréquence proche de la fréquence de résonance dont le mouvement est entretenu par le courant constant. En effet, pour ce type de dopage le silicium par exemple présente un coefficient de piézorésistivité maximal dans la direction [100] qui est négatif, contrairement au silicium de type p qui possède un coefficient de piézorésistivité maximal et positif dans la direction [110].

Avec un coefficient de piézorésistivité positif (dopage de type p), on obtient une augmentation globale de la dissipation du résonateur.

Avec un coefficient de piézorésistivité négatif, on obtient une rétroaction négative qui amplifie le mouvement : le coefficient visqueux TPBA compense le coefficient de dissipation naturelle du résonateur. Un régime d'auto-oscillation est atteint lorsque cette compensation est totale.

Cette dépendance au signe du coefficient piézorésistif est très contraignante car elle impose un type de dopage en fonction de l'effet TPBA désiré. Ce choix du dopage peut être par ailleurs soumis à d'autres contraintes, par exemple des contraintes sur des critères de détection si la piézorésistivité est utilisée comme moyen de transduction électromécanique, des contraintes sur des critères de dépendance en température de la résistance ou des moyens de transduction.

En outre, l'effet thermo-piézorésistif ne peut être annulé qu'en rendant nul le courant de polarisation. Or les nanopoutres sont fréquemment utilisées comme jauges de déformation piézorésistives, ce qui requiert un courant de polarisation pour lire les variations de résistances.

Le document Steeneken PG, Le Phan K, Goossens MJ, Koops GEJ, Brom GJ a. M, van der Avoort C, et al. « Piezoresistive heat engine and refrigerator ». Nat Phys. 2011 Apr;7(4):354-9 décrit un résonateur mettant en œuvre l'effet TPBA dont la rétroaction est contrôlée par un générateur de courant continu. Le signe de la rétroaction est contrôlé en modifiant une impédance connectée en parallèle avec la résistance de la poutre thermo-piézorésistive. En réduisant cette impédance, le signe de la rétroaction est inversé.

Le circuit électronique ainsi réalisé forme un filtre passe-haut dont la fréquence de coupure se situe autour de 300kHz. En conséquence, pour des résonateurs dont la fréquence est supérieure à cette valeur, le contrôle de la rétroaction est possible. En revanche, pour des résonateurs fonctionnant à plus basse fréquence, par exemple quelques kHz, des capacités de l'ordre du μF doivent être utilisées. Mais ces valeurs de capacité sont très difficiles à intégrer sur des électroniques intégrées telles que des ASIC (Application Specific for Integrated Circuit en terminologie anglo-saxonne) en particuliers, notamment pour des questions d'encombrement dans un contexte ou l'espace disponible pour l'électronique est souvent très contraint. Par conséquent un tel système n'est pas adapté pour des résonateurs basses fréquences, tels que des accéléromètres ou des gyromètres.

Un autre moyen pour contrôler le signe de la rétroaction TPBA repose sur le coefficient de dilatation : pour certain matériau (tungstate de zirconium, germanate de cuivre et fer, l'eau entre 0 et 4°C etc.), il peut être négatif, mais il est pour la majorité des matériaux, en particulier le silicium, positif. Cependant, cette solution est en pratique difficile voire impossible à mettre en œuvre, puisqu'elle demande de combiner à la fois des propriétés de dilatation avec des propriétés piézorésistives adéquates.

## EXPOSÉ DE L'INVENTION

C'est par conséquent un but de la présente invention d'offrir une structure microélectronique comportant au moins une masse mobile et présentant un effet thermo-piézorésistif, dans laquelle la force par effet thermo-piézorésistif peut être adaptée, par exemple pour compenser ou augmenter le coefficient de dissipation intrinsèque de la structure, sans les contraintes sur le choix du matériau piézorésistif et de son dopage de l'état de la technique, et à toute fréquence de fonctionnement de la structure, par exemple inférieure à 100 kHz.

Le but énoncé ci-dessous est atteint par une structure microélectronique comportant au moins une masse mobile reliée mécaniquement à au moins un premier élément mécanique par des premiers moyens de liaison mécanique et à un deuxième élément mécanique par des deuxièmes moyens de liaison mécanique qui sont conducteurs électriques et une source de polarisation à tension continue des deuxièmes moyens de liaison mécanique. Les deuxièmes moyens de liaison mécanique sont disposés par rapport à la masse mobile, de sorte que les déplacements de la masse mobile appliquent des contraintes de déformation mécanique aux deuxièmes moyens de liaison mécanique, et ces deuxièmes moyens de liaison mécanique étant tels qu'ils sont le siège d'un effet thermo-piézorésistif.

Les moyens de polarisation à tension continue et les deuxièmes moyens de liaison mécanique forment un circuit électrique de rétroaction thermo-piézorésistive, générant une force de rétroaction qui peut être adaptée grâce à la configuration du circuit électrique.

Les inventeurs ont déterminé qu'en polarisant à tension continue les deuxièmes moyens de liaison mécanique, un coefficient apparaissait dans la formule définissant la force de rétroaction thermo-piézorésistive, et que la valeur de ce coefficient pouvait être ajustée en fonction de la configuration électrique du circuit électrique comprenant les moyens de polarisation et les deuxièmes moyens de liaison mécanique, par exemple en fonction de la valeur d'une résistance électrique en série avec les deuxièmes moyens de liaison mécanique. Il en résulte que le coefficient d'amortissement peut être modifié, voir annulé sans être contraint de choisir des matériaux et/ou leur dopage pour disposer d'un coefficient piézorésistif de signe donné. En outre, cet effet sur le coefficient d'amortissement peut être obtenu quelle que soit la fréquence de la structure

Dans l'état de la technique, une polarisation à courant continu est réalisée. Or une telle polarisation ne fait pas apparaître de coefficient dans la formule de la force de rétroaction, qui permet d'agir simplement sur la force de rétroaction

De plus, grâce à l'invention on peut envisager d'annuler l'effet thermo-piézorésistif tout en polarisant les deuxièmes moyens de liaison mécanique afin qu'ils servent de jauge de détection de contrainte.

De manière très avantageuse, le circuit comporte des moyens de régulation du courant, par exemple comportant une résistance électrique de valeur déterminée. Avantageusement la valeur de la résistance peut être modifiée, par exemple un potentiomètre est mis en œuvre, ce qui permet de pouvoir régler facilement la valeur de la force de rétroaction. Par exemple la résistance peut prendre trois valeurs, une valeur amplifiant le coefficient d'amortissement, un valeur nulle, dans ce cas le coefficient est égal à -1 et l'effet de la rétroaction a un effet opposé à celui obtenu par exemple en polarisant en courant des moyens de liaison mécanique ayant un coefficient piézorésistif positif, et une valeur annulant le coefficient d'amortissement.

Le circuit électrique de rétroaction peut comporter un dipôle présentant une caractéristique de résistance électrique négative permettant de s'affranchir des éventuelles résistances parasites des deuxièmes moyens de liaison mécanique.

La présente invention a alors pour objet une structure microélectronique comportant au moins une masse mobile reliée mécaniquement à au moins un premier élément mécanique par des premiers moyens de liaison mécanique et à au moins un deuxième élément mécanique par des deuxièmes moyens de liaison mécanique conducteurs électriques, des moyens de polarisation électrique des deuxièmes moyens de liaison mécanique, lesdits deuxièmes moyens de liaison mécanique étant tels qu'ils sont le siège d'un effet thermo-piézorésistif, les deuxièmes moyens de liaison et la masse mobile étant disposés l'un par rapport à l'autre de sorte qu'un déplacement de la masse mobile applique une contrainte mécanique aux deuxième moyens de liaison. Les moyens de polarisation électrique sont des moyens de polarisation en tension continue et forment avec au moins les deuxièmes moyens de liaison mécanique un circuit électrique de rétroaction thermo-piézorésistive.

Les deuxièmes moyens de liaison mécanique comportent au moins un matériau conducteur électrique. Avantageusement le deuxième élément mécanique peut également être conducteur électrique lorsqu'il assure une continuité électrique entre les deuxièmes moyens de liaison mécanique et les moyens de polarisation.

Dans un exemple de réalisation, le circuit électrique de rétroaction thermo-piézorésistive comporte des moyens de régulation du courant relié électriquement en série avec les deuxièmes moyens de liaison mécanique. Les moyens de régulation du courant peuvent comporter au moins un composant électrique apte à prendre une valeur de résistance électrique déterminée. Avantageusement, le composant électrique est tel qu'il permet de sélectionner une valeur de résistance électrique déterminée parmi plusieurs valeurs de résistance électrique, l'élément électrique étant avantageusement un potentiomètre.

Dans un exemple de réalisation, les deuxièmes moyens de liaison mécanique peuvent présenter une résistance électrique donnée, et la résistance électrique des moyens de régulation peut avoir une valeur inférieure ou égale à 5 fois la valeur de résistance électrique des deuxièmes moyens de liaison mécanique à l'état de repos de la masse mobile.

Dans un autre exemple de réalisation, les deuxièmes moyens de liaison mécanique présentent une résistance électrique donnée, et la résistance électrique des moyens de régulation peut être égale à la résistance électrique des deuxièmes moyens de liaison mécanique de sorte à compenser l'effet thermo-piézorésistif

Les moyens de régulation de courant sont avantageusement réalisés sur un substrat de la structure microélectronique de sorte à réduire les capacités parasites.

Dans un autre exemple de réalisation, les moyens de régulation de courant comportent au moins un dipôle connecté en série avec les deuxièmes moyens de liaison mécanique, ledit dipôle ayant une caractéristique de résistance négative. Le dipôle peut être choisi parmi une diode tunnel, une diode Gunn, un thyristor et un circuit de rétroaction comportant au moins un amplificateur opérationnel.

Dans un autre exemple de réalisation, les moyens de régulation de courant comportent au moins une inductance connectée en série avec les deuxièmes moyens de liaison mécanique.

Selon une caractéristique additionnelle, la structure microélectronique peut comporter des moyens de contrôle actif de la tension de polarisation permettant d'appliquer une tension constante aux deuxièmes moyens de liaison mécanique.

Les moyens de contrôle actif de la tension de polarisation peuvent comporter une boucle de rétroaction en tension comprenant des moyens de mesure de la tension aux bornes des deuxièmes moyens de liaison mécanique, par exemple par une méthode 4 fils, un comparateur pour comparer ladite tension mesurée et une tension de consigne, et un correcteur envoyant un signal correctif aux moyens de polarisation.

De manière avantageuse, les deuxièmes moyens de liaison mécanique comportent une poutre.

Le premier élément mécanique peut être un plot d'ancrage solidaire d'un support et la masse mobile peut être articulée en rotation par rapport au plot d'ancrage et le deuxième élément mécanique peut être un deuxième plot d'ancrage solidaire du support.

## BRÈVE DESCRIPTION DES DESSINS

La présente invention sera mieux comprise sur la base de la description qui va suivre et des dessins en annexe sur lesquels:

- la figure 1 est une représentation schématique d'un exemple de réalisation d'une structure microélectronique selon l'invention,
- la figure 2 est une représentation d'un schéma électrique du circuit électrique de rétroaction de la structure de la figure 1,
- la figure 3 est une représentation d'un schéma électrique du circuit électrique de rétroaction comportant des résistances parasites,
- la figure 4 est une représentation d'un schéma électrique d'un autre exemple de circuit électrique de rétroaction pouvant être mis en œuvre dans la structure selon l'invention,
- la figure 5 est une représentation d'un schéma électrique d'un autre exemple de circuit électrique de rétroaction pouvant être mis en œuvre dans la structure selon l'invention, comportant un contrôle actif de la tension de polarisation,
- la figure 6 est une représentation d'un autre exemple de circuit électrique de rétroaction pouvant être mis en œuvre dans la structure selon l'invention, mettant en œuvre un dipôle ayant une caractéristique de résistance électrique négative,
- la figure 7 représente la caractéristique d'un dipôle (tension U en fonction du courant I) ayant un comportement de résistance négative au voisinage d'un point de fonctionnement $I_0$, $U_0$,
- les figures 8A à 8F sont des représentations schématiques des différentes étapes d'un exemple de procédé de réalisation d'une structure microélectronique selon la présente invention,

- la figure 9A est une représentation de la variation absolue du facteur de qualité QF d'une structure proche de celle de la figure 1 en fonction de la tension de polarisation Vc continue en mV,
- la figure 9B est une représentation de la variation du courant délivré I en $\mu$A en fonction du temps t en s,
- la figure 9C est une vue agrandie de la figure 9B au-delà de 60 s,
- la figure 10 est une représentation schématique d'un autre exemple de réalisation d'une structure microélectronique selon l'invention comportant deux deuxièmes moyens de liaison mécanique,
- la figure 11 est un exemple de schéma électrique applicable à la structure de la figure 10.

## EXPOSÉ DÉTAILLÉ DE MODES DE RÉALISATION PARTICULIERS

Dans la présente demande, on entend par « structure microélectronique » une structure résonante comportant des éléments microélectromécaniques et/ou des éléments nanoélectromécaniques.

Dans la description qui va suivre, les expressions « coefficient d'amortissement visqueux », « coefficient d'amortissement», « coefficient de dissipation », « facteur d'amortissement » et « facteur de dissipation » seront considérées comme synonymes.

Sur la figure 1, on peut voir un exemple d'une structure microélectronique S selon l'invention. La structure s'étend selon un plan moyen P défini par les axes X et Y. La structure ou résonateur comporte une masse mobile 2 apte à se déplacer par rapport à un support formé par exemple par un substrat. La masse mobile 2 est reliée au support par des premiers moyens de liaison 6 tels qu'ils autorisent un déplacement de la masse mobile 2 par rapport au support.

Dans l'exemple représenté, les premiers moyens de liaison 6 comportent une articulation pivot présentant un axe de pivot Z orthogonal au plan P. La masse mobile 2 est donc apte à se déplacer en rotation autour de l'axe Z dans le plan P. Dans l'exemple représenté, l'articulation pivot comporte deux poutres 10 s'étendant entre un plot d'ancrage 12 et la masse mobile 2, les poutres 10 ayant des axes sécants en un point O qui est l'intersection de l'axe Z et du plan P. Les poutres 10 se déforment en flexion et autorisent la rotation de la masse autour de Z. Il sera compris que la liaison pivot pourrait être réalisée autrement.

La structure comporte des deuxièmes moyens de liaison 14 entre la masse mobile 2 et un deuxième plot d'ancrage 24. Les deuxièmes moyens de liaison sont conducteurs électriques.

Comme cela sera décrit dans la suite de la description, les deuxièmes moyens de liaison 14 sont tels qu'ils exercent une force sur la masse mobile par action en retour thermo-piézorésistif. Les deuxièmes moyens de liaison 14 sont alors orientés par rapport aux premiers moyens de liaison 6, de sorte qu'ils soient sollicités mécaniquement par la masse mobile 2 en mouvement, et de sorte que la force d'action en retour Far s'applique au moins dans la direction selon laquelle la masse peut se déplacer. Dans cet exemple, la masse mobile 2 se déplace principalement selon la direction X. Les deuxièmes moyens de liaison 14 sont alors tels qu'ils exercent une force d'action en retour Far sur la masse le long de la direction X.

Les deuxièmes moyens de liaison 14 sont sollicités par la masse mobile 2. De préférence ils sont sollicités en traction et en compression, tout en autorisant des mouvements en flexion en superposition de la compression ou de la traction.

Les deuxièmes moyens de liaison 14 comportent au moins une zone à effet thermo-piézorésistif. Dans l'exemple représenté, les deuxièmes moyens de liaison mécanique comportent une poutre 18 ancrée sur la masse mobile et sur le deuxième plot d'ancrage.

L'effet thermo piézorésistif résulte d'un couplage de phénomènes électriques, thermiques et mécaniques au sein d'une structure mécanique, comme une poutre ou un système composé de poutres, possédant en totalité ou en partie des propriétés conductrices, piézorésistives et thermoélastiques. Cet effet se manifeste par l'apparition d'une force de rétroaction produite par la structure mécanique lorsqu'elle est sollicitée mécaniquement, par exemple du fait d'une déformation imposée par un élément extérieur, et lorsque la structure mécanique est polarisée électriquement. Cette force possède des composantes proportionnelles à la déformation appliquée et à la vitesse de cette déformation. Le mécanisme de cet effet est décrit par une boucle de rétroaction thermo-piézorésistive.

La poutre 18 est alors réalisée au moins en partie en un matériau piézorésistif et au moins en partie en un matériau ayant des propriétés de thermoélasticitié. La poutre 18 peut comporter deux matériaux distincts, l'un piézorésistif et l'autre thermoélastique ou alors un seul matériau à la fois piézorésistif et thermoélastique. Par exemple, le silicium et le SiGe sont à la fois piézorésistifs et thermoélastiques. Dans le cas où la poutre comporte plusieurs matériaux, il peut s'agir d'aluminium ayant un coefficient de dilatation de 23 ppm/K, alors que celui du silicium est de 2ppm/K, associé à un matériau piézorésistif comme le silicium. On peut envisager que la poutre comporte une alternance de portions de ces matériaux disposées dans la direction de la longueur de la poutre.

Dans la présente demande, on considère qu'un élément présente des propriétés thermoélastiques s'il présente un coefficient de dilatation à la température de travail supérieure à $10^{-7}K^{-1}$.

Les deuxièmes moyens de liaison 14 sont tels qu'ils sont aptes à exercer des efforts mécaniques sur la masse mobile 2. Pour cela, ils présentent une certaine raideur et leur connexion au deuxième plot d'ancrage est telle que la force Far déplace préférentiellement la masse mobile.

La structure comporte également des moyens de polarisation 15 en tension continue de ces deuxièmes moyens de liaison. Par exemple les moyens de polarisation 15 comportent un générateur de tension continue appliquant une tension continue Vc au circuit de rétroaction thermo-piézorésistive.

Les moyens de polarisation 15 forment avec les deuxièmes moyens de liaison mécanique un circuit électrique de rétroaction.

Dans l'exemple représenté, la masse mobile 2, les premiers moyens de liaison mécanique et le premier plot d'ancrage également sont conducteurs électriques et le premier plot d'ancrage est relié à la terre. Ainsi ils forment avec les moyens de polarisation et les deuxièmes moyens de liaison mécanique un circuit électrique fermé. Mais on pourrait prévoir de ne polariser que les deuxièmes moyens de liaison mécanique, par exemple en reliant à la terre l'extrémité de la poutre 18 connectée à la masse mobile 2 avec une connexion électrique présentant avantageusement une raideur mécanique négligeable selon les directions de l'espace par rapport aux autres connexions mécaniques. La connexion électrique aurait alors un impact limité sur le comportement mécanique de la structure.

Dans l'exemple représenté, le circuit électrique de rétroaction thermo-piézorésistive C comporte une résistance électrique Rc branchée en série avec la poutre 18 et disposée entre une borne des moyens de polarisation 15 et le deuxième plot d'ancrage 24. La résistance peut être réalisée directement sur le substrat de la structure microélectronique ou être réalisée à l'extérieur de la structure, par exemple sur un circuit Intégré à Application Spécifique ou ASIC dissocié de la structure.

Sur la figure 2 on peut voir le schéma électrique du circuit de rétroaction C. La poutre 18 est représentée par sa résistance électrique variable Rpo + δRp. Rpo est la valeur de la résistance électrique de la poutre à l'état repos (non soumise à une contrainte mécanique par la masse mobile) qui est une constante, et δRp est la variation de résistance électrique de la poutre du fait d'une contrainte mécanique appliquée par la masse mobile à la poutre dont au moins une partie est en matériau piézorésistif. I est le courant dans le circuit.

Le fonctionnement du circuit de rétroaction est le suivant.

La tension de polarisation $V_c$ polarise le circuit. Le courant $I$ prend ainsi la valeur suivante :

$$I = I_0 + \delta I \approx \frac{V_c}{R_c + R_{p0}}\left(1 - \frac{\delta R_p}{R_c + R_{p0}}\right)$$

En considérant δRp << Rc + Rpo, par exemple δRp/Rpo < 3%.

Soit

$$\delta I = -\frac{\delta R_p}{\left(R_c + R_{p0}\right)^2} V_c$$

La puissance délivrée à la poutre 18 peut ensuite être estimée à :

$$P = \left(R_{p0} + \delta R_p\right)(I_0 + \delta I)^2$$

Soit au premier ordre en $\delta R_p$

$$P \approx R_{p0}\left(\frac{V_c}{R_c + R_{p0}}\right)^2\left(1 + \delta R_p \frac{R_c - R_{p0}}{R_{p0}\left(R_c + R_{p0}\right)}\right)$$

La puissance délivrée à la poutre TPBA prend la forme :

$$P = P_0 + \delta P$$

En posant

$$I_0 = \frac{V_c}{R_c + R_{p0}}$$

$$P_0 = R_{p0} \left( \frac{V_c}{R_c + R_{p0}} \right)^2 = R_{p0} I_0^2$$

et

$$\delta P = \eta \frac{\delta R_p}{R_{p0}}$$

Avec

$$\eta = \frac{R_c - R_{p0}}{R_c + R_{p0}}$$

La force générée par l'effet thermo-piézorésistif ou force de rétroaction s'écrit

$$F(\omega) = \eta E \alpha R_{th} I_0^2 \pi_g R_{p0} \frac{x - j\tau_{th}\dot{x}}{1 + (\omega\tau_{th})^2}$$

Ainsi en choisissant la valeur de Rc, on peut modifier le coefficient η et donc la force de rétroaction. Par exemple, il est possible de faire varier le coefficient η de -1 à +1 lorsque Rc>0.

La résistance permet donc de réguler le courant dans le circuit électrique de rétroaction piézorésistive C et donc de régler l'effet d'action en retour.

En jouant sur la valeur de la résistance $R_c$ par rapport à la résistance $R_{p0}$, il est possible de faire varier le paramètre η de -1 à +1.

Il est donc possible de contrôler le signe et la présence de l'effet d'action thermo-piézorésistif, en ajustant la valeur de $R_c$ par rapport à $R_p$ sur une large gamme de fréquence de fonctionnement de la structure microélectronique.

Dans le schéma électrique la résistance Rc a une valeur fixe.

De préférence Rc est égale à au plus 5 fois la valeur de Rp0, afin de limiter la consommation énergétique.

La résistance Rc est une résistance dont la valeur est déterminée, soit il s'agit d'une valeur fixe qui ne peut pas être modifiée, soit c'est une valeur modifiable comme selon sera décrit par la suite. La résistance Rc est une résistance ajoutée volontairement dans le circuit électrique de rétroaction thermo-piézorésistive et dont l'effet sur la force d'action en retour est déterminé, la résistance Rc est distincte des résistances parasites qui existent par exemple au niveau des pistes d'accès, mais dont la valeur n'est pas déterminée.

Des valeurs de Rc présentant un intérêt particulier sont données ci-dessous,

Pour Rc=Rpo, le coefficient η a pour valeur η=0. Dans ce cas, l'effet est compensé. Le résonateur retrouve son coefficient de dissipation naturel, il n'y a plus d'effet d'action en retour thermo-piézorésistif.

Pour Rc>>Rpo, le coefficient η a pour valeur η=1. Dans ce cas, la rétroaction a le même signe que l'effet habituellement obtenu lorsque la polarisation est en courant.

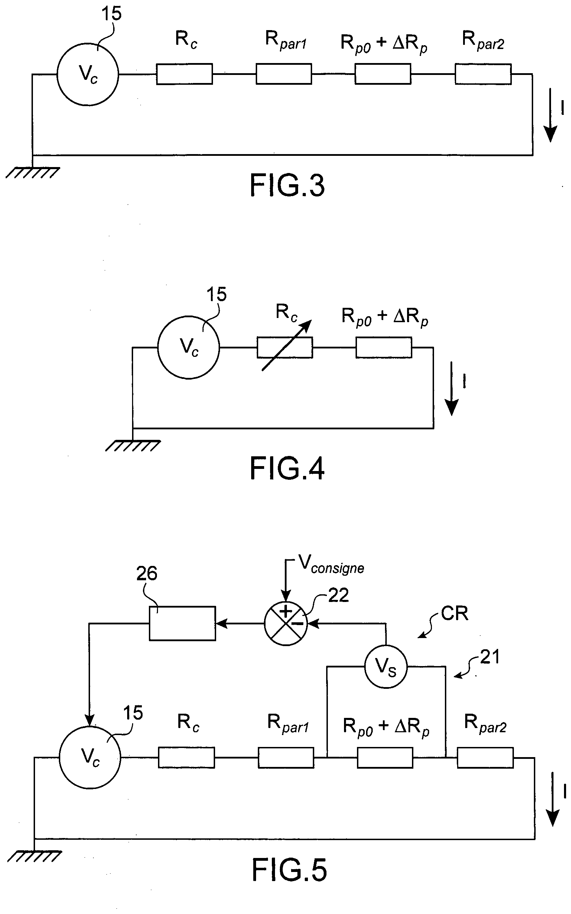

Pour Rc=0 ou Rc<<Rp0, le coefficient η a pour valeur η=-1. Dans ce cas, la rétroaction a un signe opposé à l'effet habituellement obtenu lorsque la polarisation est en courant. Dans ce cas particulier, la structure est réalisée de sorte que les résistances électriques parasites en série avec la poutre soient réduites. Sur la figure 3, ces résistances parasites sont désignées par Rpar1 et Rpar2. Ces résistances parasites peuvent résulter des pistes d'accès à la poutre 18, en effet leur résistivité n'est pas toujours négligeable. Elles peuvent atteindre quelques dizaines de pourcents de la valeur de résistance de la poutre voire dépasser cette valeur. Les résistances pourraient être réduites structurellement par exemple en utilisant des matériaux à forte conductivité jusqu'à l'ancrage de la poutre, en dimensionnant les pistes d'accès...

Grâce à l'invention, l'action sur la force de rétroaction peut avoir lieu sur une large gamme de fréquence de fonctionnement, des fréquences nulles jusqu'à des fréquences élevées.

La limite supérieure de la fréquence est fixée par des capacités parasites Cpar. Une fréquence haute $\omega_c$ =

$1/R_cC_{par}$ peut limiter la plage de fonctionnement du système.

De manière avantageuse, la résistance $R_c$ est intégrée sur le substrat de la structure microélectronique à proximité des deuxièmes moyens de liaison18 afin de réduire la capacité parasite à une valeur inférieure à 100 fF. La limite supérieure des fréquences peut ainsi être repoussée à une valeur de l'ordre de la centaine de Mégahertz.

Sur la figure 4, on peut voir un autre exemple de réalisation d'un circuit de rétroaction très avantageux, dans lequel la résistance Rc comporte un potentiomètre permettant de contrôler in situ et très précisément le signe de la rétroaction. Il est également possible par ce biais d'activer ou de désactiver l'effet d'action en retour dans la structure microélectronique. Lorsque la résistance Rc est augmentée en manipulant le potentiomètre, le courant moyen délivré tend à diminuer, ce qui a pour effet de réduire l'effet d'action en retour. De manière avantageuse la tension de polarisation est ajustée pour que le courant moyen délivré soit constant. Par exemple, on peut assujettir la valeur de la tension de polarisation à la valeur de Rc. Cependant on peut conserver un contrôle indépendant de la source de tension.

En variante, la résistance pourrait être remplacée par un dispositif capable de prendre plusieurs valeurs discrètes de résistance, par exemple trois valeurs, par exemple nulle, égale à Rpo et une valeur très supérieure à Rpo.

Le potentiomètre peut être intégré sur la puce de la structure microélectronique ou dans un ASIC à partir d'une technologie de transistor à effet de champ à jonction ou JFET (Junction Field Effect Transistor en terminologie anglo-saxonne) par exemple utilisée pour les composants suivants : Vishay AN105®, Fairchild®, Philips semiconductor BF245C®.

Sur la figure 5, on peut voir un autre exemple de circuit de rétroaction comportant des moyens de contrôle actif de la tension de polarisation.

Comme cela a déjà été expliqué ci-dessus, le circuit peut comporter des résistances parasites dont il est préférable de réduire l'effet. Pour cela, le circuit comporte des moyens de contrôle actif de la tension de polarisation mettant en œuvre une boucle de rétroaction en tension BR.

La résistance minimale en série avec la résistance Rp de la poutre 18 est réduite à $R_{par1} + R_{par2}$. Ces résistances parasites limitent la valeur du coefficient $\eta$ à :

$$\eta(R_c) = \frac{R_c + R_{par1} + R_{par2} - R_{p0}}{R_c + R_{par1} + R_{par2} + R_{p0}} \geq \frac{R_{par1} + R_{par2} - R_{p0}}{R_{par1} + R_{par2} + R_{p0}} > -1$$

Les moyens de contrôle actif de la tension de polarisation comportent des moyens 21 pour sonder la tension Vs aux bornes de la poutre 18, par exemple par la méthode 4 fils, bien connue de l'homme du métier, ce qui permet de s'affranchir de l'effet des résistances parasites.

Pour cela, des pistes d'accès dissociées du circuit de polarisation sont réalisées jusqu'aux extrémités de la poutre 18. L'utilisation d'une sonde de tension d'impédance élevée par rapport à l'impédance de ces pistes et de celle de la poutre 18 réunies permet de mesurer précisément la tension aux bornes de la poutre 18.

Les moyens de contrôle comportent également un comparateur 22 pour comparer cette tension mesurée aux bornes de la poutre à une valeur de consigne $V_{consigne}$, et un correcteur 26 qui pilote le générateur de tension $V_c$ sur la base du signal émis par le comparateur afin d'éliminer le signal d'erreur $\varepsilon = V_{consigne} - V_s$.

Grâce à ces moyens de contrôle actif, la tension aux bornes de la poutre 18 est maintenue constante et égale à $V_{consigne}$. L'effet d'action en retour obtenu est sensiblement celui obtenu pour $\eta = -1$ car les résistances parasites et Rc n'ont alors plus d'influence.

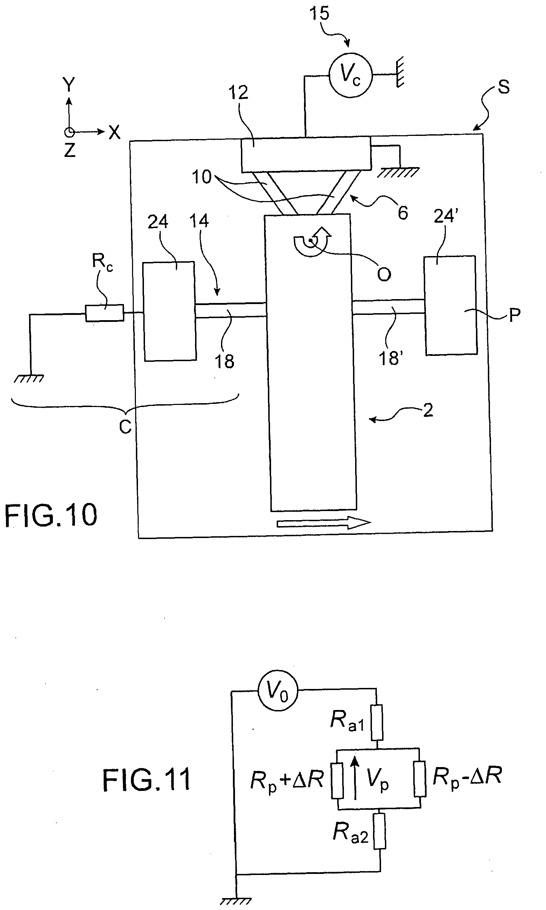

Sur la figure 10, on peut voir un autre exemple de réalisation d'une structure microélectronique selon l'invention, qui diffère de la structure de la figure 1, en ce qu'il comporte une deuxième poutre 18' suspendue entre la masse 2 et un plot 24'. La poutre 18' et le plot 24' sont symétriques du plot 24 et de la poutre 18 par rapport à un plan passant par l'axe de rotation de la masse. Cette structure peut être utilisée dans un dispositif inertiel, par exemple un accéléromètre, les poutres formant des jauges montées en différentiel.

Sur la figure 11, on peut voir le schéma électrique de la structure de la figure 10. Les deux poutres sont connectées en parallèle à la source de polarisation 15 et les deux poutres sont reliées électriquement. Ce montage permet avantageusement de maintenir constante la tension de polarisation aux bornes des poutres en mettant en commun les résistances d'accès.

$R_{p1}$ est la résistance de la poutre 18 sans sollicitation mécanique et $\Delta R_1$ est la variation de la résistance $R_{p1}$ lorsqu'elle est soumise à une contrainte.

$R_{p2}$ est la résistance de la poutre 18' sans sollicitation mécanique et $\Delta R_2$ est la variation de la résistance $R_{p2}$ lorsqu'elle est soumise à une contrainte.

Les résistances $R_{p1}$ et $R_{p2}$ ont des variations de résistances opposées, en effet lorsque l'une des poutres est comprimée, l'autre est étirée.

$R_{a1}$ et $R_{a2}$ sont les résistances d'accès. Dans cette configuration, les résistances d'accès $R_{a1}$ et $R_{a2}$ sont mises en commun pour les deux éléments piézorésistifs 18 et 18'. La résistance équivalente du dipôle formé par les deux éléments 18et 18' en parallèle ne dépend pas au premier ordre de la variation de résistance ∆R qui a lieu de manière opposée dans chacun de ces deux éléments.

En effet, en considérant $R_{p1} = R_{p2}$

$$R_{eq} = \frac{R_{p1}}{2} - \frac{\Delta R_1^{\;2}}{2R_{p1}}$$

Dans ces conditions, la tension aux bornes des deux éléments piézorésistifs restent constante au premier ordre en ∆R1.

$$\boldsymbol{V_p} = \frac{R_{p1}V_0}{R_{p1} + R_{a1} + R_{a2}}$$

De manière avantageuse, on choisit :

- des résistances $R_{p1}$ et $R_{p2}$ sensiblement identiques à 20% près,
- des variations de résistances opposées $\Delta R_1$ et $\Delta R_2$ de modules identiques à 20% près.

Alors

$$V_p = \frac{R_{eq0}V_0}{R_{a1} + R_{a2} + R_{eq0}}\left(1 - \epsilon\, \frac{R_{p1} - R_{p2}}{R_{p1} + R_{p2}}\left(1 - \frac{R_{eq0}}{R_{a1} + R_{a2} + R_{eq0}}\right)\right)$$

Avec

$$R_{eq0} = \frac{R_{p1}R_{p2}}{R_{p1}+R_{p2}}$$

Et $\epsilon = \frac{\Delta R_1}{Rp1} = -\frac{\Delta R_2}{R_{p2}}$ que l'on suppose opposés dans le cas présent.

Le facteur $\frac{R_{p1}-R_{p2}}{R_{p1}+R_{p2}}$ caractérise le déséquilibre recherché.

En variante, seule une des deux résistances d'accès peut être mise en commun.

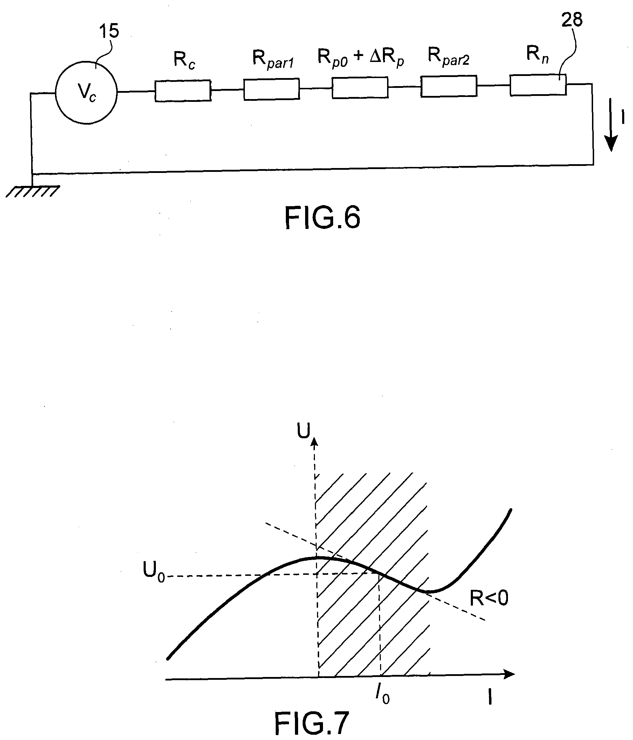

Sur la figure 6, on peut voir un autre exemple de circuit de rétroaction selon l'invention mettant en œuvre un dipôle 28 présentant une caractéristique de résistance négative Rn. Le dipôle 28 est connecté en série électriquement avec la poutre18.

L'utilisation d'un tel dipôle permet avantageusement de s'affranchir de la présence de résistances parasites dans le circuit de rétroaction.

Le dipôle 28 présente une caractéristique de résistance négative, au moins au voisinage d'un point de fonctionnement $U_0, I_0$ (figure 7). Ce type de comportement peut être obtenu avec des dipôles du type diode tunnel, diode Gunn, thyristors, par un circuit de rétroaction à base d'amplificateur opérationnel ou tout composant connu de l'homme du métier présentant une caractéristique de résistance négative.

Pour un courant nominal $I_0$ souhaité au repos dans la poutre 18, la tension du générateur à appliquer peut être estimée $V_c = U_0 + (R_c + R_{par1} + R_{par2} + R_{p0})I_0$. Au voisinage de ce point, le dipôle possède le comportement suivant :

$$U = U_0 + R_n(I - I_0)$$

Ainsi en présence d'une variation de résistance $\delta R_p$ de la poutre, le nouvel équilibre est obtenu pour $I = I_0 + \delta I$

$$V_c = U_0 + \left(R_c + R_{par1} + R_{par2} + R_{p0} + R_n + \delta R_p\right)(I_0 + \delta I) - R_n I_0$$

Soit

$$0 \approx \delta R_p I_0 + \big( R_c + R_{par1} + R_{par2} + R_{p0} + R_n \big) \delta I$$

$$\frac{\delta I}{I_0} \approx - \frac{\delta R_p}{\big( R_c + R_{par1} + R_{par2} + R_{p0} + R_n \big)}$$

La modulation de puissance aux bornes de la poutre 18 a pour expression :

$$P_0 + \delta P = \big( R_{p0} + \delta R_p \big)(I_0 + \delta I)^2$$

$$\frac{\delta P}{P_0} = \frac{\delta R_p}{R_{p0}} - 2 \frac{\delta R_p}{\big( R_c + R_{par1} + R_{par2} + R_{p0} + R_n \big)}$$

Enfin :

$$\frac{\delta P}{P_0} = \eta_n \frac{\delta R_p}{R_{p0}}$$

Avec :

$$\eta_n = \frac{R_c + R_{par1} + R_{par2} + R_n - R_{p0}}{R_c + R_{par1} + R_{par2} + R_n + R_{p0}}$$

La force exercée sur le système prend ensuite la forme :

$$F(\omega) = \eta_n E \alpha R_{th} I_0^2 \pi_g R_{p0} \frac{x - j\tau_{th}\dot{x}}{1 + (\omega \tau_{th})^2}$$

Le facteur $\eta_n$ peut en effet atteindre -1 lorsque $R_c = 0$ et $R_n$ compense $R_{par1} + R_{par2}$. Cet exemple de réalisation permet alors de pallier le problème de la présence des résistances parasites. En outre, ce système permet de renforcer l'effet d'action en retour inverse. En effet pour une résistance négative $R_n$ de valeur absolue qui s'approche de la somme des résistances constituant le circuit $R_c + R_{par1} + R_{par2} + R_{p0}$, le coefficient $\eta_n$ diverge vers l'infini par valeur négative : ceci a lieu pour $R_c + R_{par1} + R_{par2} + R_n + R_{p0} \sim 0$. L'auto-oscillation apparait dès que l'amortissement est compensé. En présence d'un coefficient d'amortissement négatif, en plus de l'auto-oscillation, le temps de réponse mécanique diminue avec l'intensité de $\eta_n$ et le système atteint plus vite son régime d'auto-oscillation après une perturbation donnée.
De préférence $R_c$ est choisie proche de 0 afin de réduire la dissipation par effet Joule.
Grâce à l'invention, il est possible de compenser la dissipation dans l'air. En effet, l'invention permet d'amplifier le coefficient de dissipation par un facteur supérieur à 1 en valeur absolue, les valeurs du coefficient de dissipation dans l'air et du coefficient de dissipation par effet en retour se rapprochent alors l'une de l'autre.
Selon une variante, la résistance $R_c$ peut être remplacée ou complétée par une inductance de valeur $L$. L'inductance produit en effet une impédance faible à basse fréquence et une impédance qui diverge à haute fréquence (fréquence de coupure $R_p/L$). Ceci permet de stabiliser le courant au-dessus de la fréquence de coupure. En associant une inductance à la résistance Rc, on peut piloter différemment les effets de dissipation sur deux modes de vibration situés en dessous et au-dessus de la fréquence de coupure. En dessous de la fréquence de coupure, l'effet thermo-piézorésistif est piloté par la résistance $R_c$ et au-dessus de la fréquence de coupure l'effet thermo-piézorésistif est piloté par l'inductance
Comme cela a été indiqué ci-dessus, l'effet d'action en retour peut être compensé théoriquement lorsque Rc = Rp0. Mais en pratique, cette compensation peut avoir lieu pour une valeur de Rc différente de $R_{p0}$, en particulier si un effet de modulation de la conductivité thermique à la contrainte mécanique est également présent. En effet la modulation de température dans la poutre TPBA dépend non seulement:

- de la modulation de puissance $\delta P = \eta I_0^2 \pi_g R \frac{x}{L}$

- mais aussi de la modulation de résistance thermique résultante $\delta R_{th} = \frac{\pi_\sigma R_{th0} x}{L}$ ou $\pi_\sigma$ est un coefficient qui caractérise la sensibilité de la conductivité thermique à la déformation mécanique $x/L$.

L étant la longueur de la poutre 18.

La force thermoélastique peut s'écrire :

$$F(\omega) = E\alpha R_{th0} R_{p0} I_0^2 \frac{\eta \pi_g + \pi_\sigma}{L} \frac{x - \tau_{th}\dot{x}}{1 + (\omega\tau_{th})^2}$$

Le signe de la rétroaction et son intensité sont en particulier contrôlés par le facteur :

$$\eta + \frac{\pi_\sigma}{\pi_g}$$

La valeur de $\eta$ peut être ajustée de manière à compenser le terme $\frac{\pi_\sigma}{\pi_g}$. En pratique, la sensibilité du coefficient de conduction thermique $\pi_\sigma$ est faible par rapport au coefficient de piézorésistivité $\pi_g$ qui entre dans la modulation de puissance dissipée : la valeur de $R_c$ qui permet la désactivation de l'effet thermo-piézorésistif sera proche de $R_p$ à quelques dizaines de pourcents près.

Dans l'exemple de la figure 1, la masse est mobile en rotation dans le plan de la structure. Toute structure dont la masse est mobile en translation et/ou en rotation dans le plan et/ou hors-plan entre dans le cadre de la présente invention.

La présente invention peut s'appliquer à toute structure comportant une poutre à effet thermo-piézorésistif. Par exemple elle peut s'appliquer à une structure comportant deux masses mobiles reliées mécaniquement, une résistance Rc pourrait être placée en série avec les deuxièmes moyens de liaison mécanique entre les deux masses, deux moyens de liaison reliant la résistance Rc à l'autre masse, ces autres moyens de liaison n'ayant par exemple par d'effet thermo-piézorésistif, et/ou ayant une raideur négligeable. On peut envisager de disposer

Concernant les deuxièmes moyens de liaison mécanique, ils sont préférentiellement formés par une poutre rectiligne, mais il peut être envisagé qu'ils comportent plusieurs portions de poutre dont les axes forment un angle entre eux. L'angle est choisi faible de sorte que l'action en retour dans les deuxièmes moyens de liaison serve préférentiellement à appliquer un effort sur les ancrages et non à déformer la poutre en elle-même. En variante encore, on peut envisager des deuxièmes moyens de liaison mécanique en forme d'arc de cercle.

Les deuxièmes moyens de liaison mécanique sont choisis de sorte que leur raideur mécanique dans la direction du mouvement de la masse soit comparable ou supérieure à la raideur de la masse mobile couplée aux premiers éléments de liaison mécanique selon la même direction.

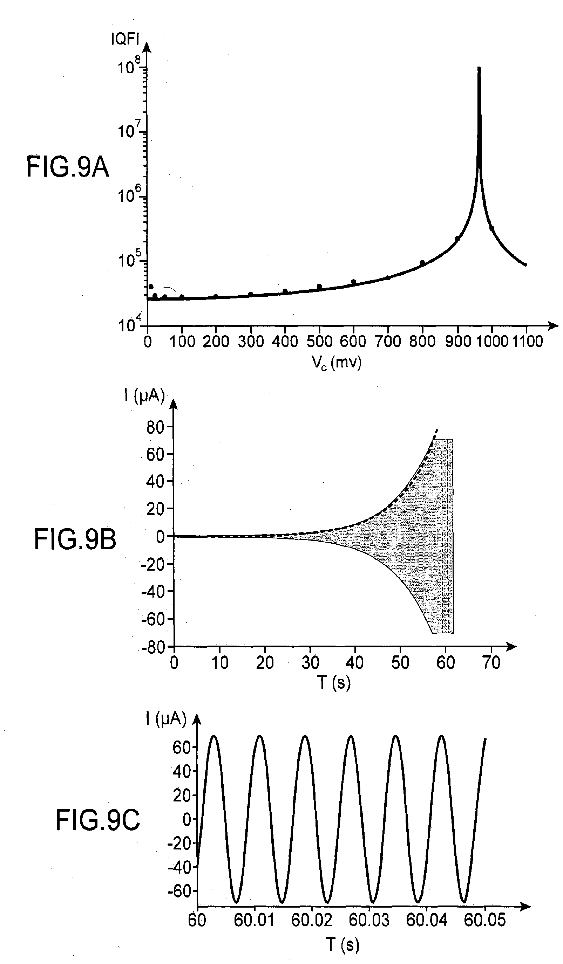

Les figures 9A à 9C représentent des résultats expérimentaux obtenus sur une structure proche de la structure de la figure 1. Une polarisation en tension d'une poutre à effet thermo-piézorésistif, en silicium dopé p à 5e19 cm$^{-3}$, est réalisée en présence d'une résistance Rc très inférieure à la résistance Rp.

On observe un effet de réduction du coefficient de friction, qui se traduit sur la figure 9A par une augmentation du facteur de qualité QF. Grâce à l'invention, on obtient une réduction de la dissipation pour des poutres en silicium dopé p, alors que dans l'état de la technique cette réduction n'était envisageable que pour des poutres dopé n au moins à basse fréquence (<100kHz). On constate que pour une tension de polarisation à partir de 900 mV, l'effet thermo-piézorésistif compense totalement les pertes intrinsèques du résonateur.

La figure 9B montre la séquence temporelle de la structure MEMS dont une polarisation à 1V est effectuée à environ t=20s. On observe une croissance exponentielle de l'amplitude du courant délivré. L'amplitude se stabilise ensuite en raison des non linéarités du système qui rééquilibrent les échanges d'énergie du résonateur avec l'extérieur. La figure 9C montre une vue agrandie de la zone de stabilisation.

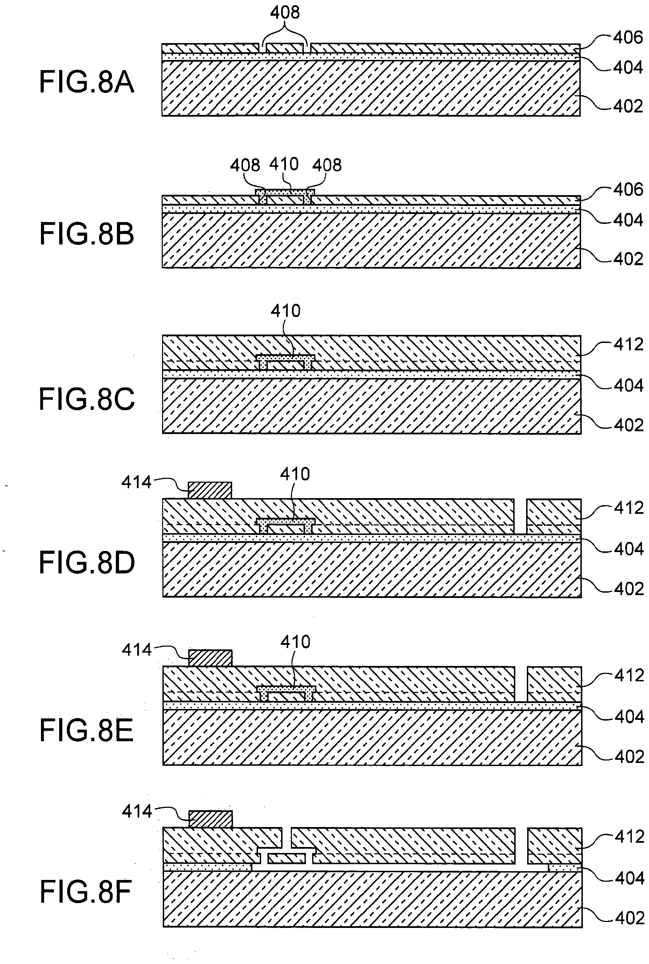

Nous allons maintenant décrire un exemple d'un procédé de réalisation d'une structure selon l'invention, dont on peut voir représentées schématiquement différentes étapes sur les figures 8A à 8F.

On utilise, par exemple une structure SOI (Silicium on insulator) comportant un substrat 402, une couche d'oxyde enterré BOX (Buried oxide) 404, et une couche de silicium 406. La couche de silicium 406 a par exemple une épaisseur de l'ordre de 200 nm. D'une manière générale, la couche 406 peut être du Si, SiGe ou Ge poly ou monocristallin.

On réalise ensuite une structuration de la couche de silicium 406, par exemple par photolithographie et gravure avec arrêt sur la couche d'oxyde 406, ce qui permet de définir les moyens de liaison.

L'élément ainsi obtenu est représenté sur la figure 8A.

Lors d'une étape suivante, on effectue un dépôt d'une couche d'oxyde 410 sur la couche silicium 406 pour combler les zones 408 préalablement gravées, on effectue ensuite une gravure de la couche d'oxyde 410 pour ne laisser subsister qu'une portion d'oxyde déposé sur la couche de silicium 406 et reliant l'oxyde remplissant les tranchées. La gravure peut être réalisée par gravure sèche avec arrêt sur Si ou par gravure humide, par exemple en utilisant une solution à base d'acide sulfurique.

L'élément ainsi obtenu est représenté sur la figure 8B.

Lors d'une étape suivante, on forme un dépôt d'une couche de silicium 412. La couche 412 est obtenue par exemple, par croissance épitaxiale, et présente une épaisseur typique de 1 à 50 $\mu$m, par exemple 10 $\mu$m. Plus généralement, la couche 412 peut être constituée de Si, SiGe, Ge, poly ou monocristallin ou d'un matériau métallique ; le dépôt peut être réalisé par épitaxie ou par des méthodes de type dépôt physique/chimique en phase vapeur (PVD/CVD : Physical/Chemical Vapor Déposition).

L'élément ainsi obtenu est représenté sur la figure 8C.

Lors d'une étape suivante, on réalise des contacts électriques 414. Pour cela, on effectue un dépôt d'une couche métallique (AlSi ou Au par exemple), on distingue les zones à supprimer et à conserver par photolithographie. On grave ensuite par gravure sèche avec arrêt sur Si ou par gravure humide sélective par rapport au Si la couche métallique pour ne conserver que les contacts 414.

L'élément ainsi obtenu est représenté sur la figure 8D.

Lors d'une étape suivante, on structure les couches de silicium 406 et 412 pour définir la masse mobile et les premiers moyens de liaison et les deuxièmes moyens de liaison, par exemple par photolithographie et gravure profonde avec arrêt sur les couches d'oxyde 404 et 410.

L'élément ainsi obtenu est représenté sur la figure 8E.

Lors d'une étape suivante, on libère la masse mobile et les premiers et deuxièmes moyens de liaison, par exemple par gravure humide de l'oxyde 404, par exemple au moyen d'acide fluorhydrique (HF) liquide et/ou vapeur. Il s'agit d'une gravure au temps. L'acide fluorhydrique est laissé au contact de la couche d'oxyde le temps nécessaire pour libérer la masse mobile, les premiers et deuxièmes moyens de liaison tout en laissant la couche d'oxyde entre le substrat et les parties fixes.

L'élément ainsi obtenu est représenté sur la figure 8F.

Les micro et nanostructures MEMS/NEMS selon l'invention offrant des moyens de contrôle de l'amortissement visqueux peuvent par exemple être mises en œuvre dans les micro-capteurs et les micro-actionneurs MEMS/NEMS.

## Revendications

1. Structure microélectronique résonante comportant au moins une masse mobile (2) reliée mécaniquement à au moins un premier élément mécanique par des premiers (6) moyens de liaison mécanique et à au moins un deuxième élément mécanique par des deuxièmes moyens de liaison mécanique (14) conducteurs électriques, ladite masse étant configurée pour être mise en vibration par un stimulus extérieur, des moyens de polarisation électrique (15) des deuxièmes moyens de liaison mécanique (14), lesdits deuxièmes moyens de liaison mécanique (14) étant tels qu'ils sont le siège d'un effet thermo-piézorésistif, les deuxièmes moyens de liaison (14) et la masse mobile (2) étant disposés l'un par rapport à l'autre de sorte qu'un déplacement de la masse mobile (2) applique une contrainte mécanique aux deuxième moyens de liaison (14), dans laquelle les moyens de polarisation électrique (15) forment avec au moins les deuxièmes moyens de liaison mécanique (14) un circuit électrique de rétroaction thermo-piézorésisitve, **caractérisée en ce que** les moyens de polarisation électrique (15) sont des moyens de polarisation en tension continue.

2. Structure microélectronique résonante selon la revendication 1, dans laquelle le circuit électrique de rétroaction thermo-piézorésistive comporte des moyens de régulation du courant relié électriquement en série avec les deuxièmes moyens de liaison mécanique.

3. Structure microélectronique résonante selon la revendication 2, dans laquelle les moyens de régulation du courant comportent au moins un composant électrique (Rc) apte à prendre une valeur de résistance électrique déterminée.

4. Structure microélectronique résonante selon la revendication 3, dans laquelle le composant électrique (Rc) est tel qu'il permet de sélectionner une valeur de résistance électrique déterminée parmi plusieurs valeurs de résistance électrique, l'élément électrique étant avantageusement un potentiomètre.

5. Structure microélectronique résonante selon la revendication 3 ou 4, dans laquelle les deuxièmes moyens de liaison mécanique (14) présentent une résistance électrique donnée et dans laquelle la résistance électrique des moyens de régulation a une valeur inférieure ou égale à 5 fois la valeur de résistance électrique des deuxièmes moyens de liaison mécanique (14) à l'état de repos de la masse mobile (2).

6. Structure microélectronique résonante selon la revendication 3 ou 4, dans laquelle les deuxièmes moyens de liaison mécanique (14) présentent une résistance électrique donnée et dans laquelle la résistance électrique des moyens de régulation est égale à la résistance électrique des deuxièmes moyens de liaison mécanique (14) de sorte à compenser l'effet thermo-piézorésistif

7. Structure microélectronique résonante selon l'une des revendications 2 à 6, dans laquelle les moyens de régulation de courant comportent au moins un dipôle (28) connecté en série avec les deuxièmes moyens de liaison mécanique (14), ledit dipôle ayant une caractéristique de résistance négative au voisinage du point de fonctionnement de la structure microélectronique résonante.

8. Structure microélectronique résonante selon la revendication 7, dans laquelle le dipôle (28) est choisi parmi une diode tunnel, une diode Gunn, un thyristor et un circuit de rétroaction comportant au moins un amplificateur opérationnel.

9. Structure microélectronique résonante selon l'une des revendications 2 à 8, dans laquelle les moyens de régulation de courant comportent au moins une inductance connectée en série avec les deuxièmes moyens de liaison mécanique.

10. Structure microélectronique résonante selon l'une des revendications 2 à 9, comportant des moyens de contrôle actif de la tension de polarisation permettant d'appliquer une tension constante aux deuxièmes moyens de liaison mécanique.

11. Structure microélectronique résonante selon la revendication 10, dans laquelle les moyens de contrôle actif de la tension de polarisation comportent une boucle de rétroaction en tension (CR) comprenant des moyens de mesure (21) de la tension aux bornes des deuxièmes moyens de liaison mécanique, par exemple par une méthode 4 fils, un comparateur (22) pour comparer ladite tension mesurée et une tension de consigne, et un correcteur (26) envoyant un signal correctif aux moyens de polarisation.

12. Structure microélectronique résonante selon l'une des revendications 1 à 11, dans laquelle les deuxièmes moyens de liaison mécanique (14) comportent une poutre (18).

13. Structure microélectronique résonante selon l'une des revendications 1 à 12, dans laquelle le premier élément mécanique est un plot d'ancrage solidaire d'un support et la masse mobile (2) est articulée en rotation par rapport au plot d'ancrage et dans laquelle le deuxième élément mécanique (24) est un deuxième plot d'ancrage solidaire du support.

**Patentansprüche**

1. Mikroelektronische Resonanzstruktur, umfassend wenigstens eine bewegliche Masse (2), die mechanisch mit wenigstens einem ersten mechanischen Element mittels erster mechanischer Verbindungsmittel (6) verbunden ist, und mit wenigstens einem zweiten mechanischen Element mittels zweiter mechanischer Verbindungsmittel (14), die elektrisch leitend sind, wobei die Masse dazu konfiguriert ist, durch einen äußeren Stimulus in Vibration versetzt zu werden, elektrische Polarisationsmittel (15) der zweiten mechanischen Verbindungsmittel (14), wobei die zweiten mechanischen Verbindungsmittel (14) derart sind, dass sie der Sitz eines thermopiezoresistiven Effekts sind, wobei die zweiten Verbindungsmittel (14) und die bewegliche Masse (2) relativ zueinander derart angeordnet sind, dass eine Verlagerung der beweglichen Masse (2) eine mechanische Beanspruchung auf die zweiten Verbindungsmittel (14) ausübt, wobei die elektrischen Polarisationsmittel (15) mit wenigstens den zweiten mechanischen Verbindungsmitteln (14) einen elektrischen thermopiezoresistiven Rückkopplungskreis bilden, **dadurch gekennzeichnet, dass** die elektrischen Polarisationsmittel (15) Gleichspannungspolarisationsmittel sind.

**2.** Mikroelektronische Resonanzstruktur nach Anspruch 1, bei der der elektrische thermopiezoresistive Rückkopplungskreis Stromregelmittel umfasst, die elektrisch in Reihe mit den zweiten mechanischen Verbindungsmitteln verbunden sind.

**3.** Mikroelektronische Resonanzstruktur nach Anspruch 2, bei der die Stromregelmittel wenigstens eine elektrische Komponente (Rc) umfassen, die dazu ausgelegt ist, einen bestimmten elektrischen Widerstandswert anzunehmen.

**4.** Mikroelektronische Resonanzstruktur nach Anspruch 3, bei der die elektrische Komponente (Rc) derart ist, dass sie die Auswahl eines gegebenen elektrischen Widerstandwerts aus mehreren elektrischen Widerstandswerten erlaubt, wobei das elektrische Element vorzugsweise ein Potentiometer ist.

**5.** Mikroelektronische Resonanzstruktur nach Anspruch 3 oder 4, bei der die zweiten mechanischen Verbindungsmittel (14) einen gegebenen elektrischen Widerstand aufweisen, und bei der der elektrische Widerstand der Regelmittel einen Wert kleiner oder gleich 5 Mal dem elektrischen Widerstandswert der zweiten mechanischen Verbindungsmittel (14) im Ruhezustand der beweglichen Masse (2) hat.

**6.** Mikroelektronische Resonanzstruktur nach Anspruch 3 oder 4, bei der die zweiten mechanischen Verbindungsmittel (14) einen gegebenen elektrischen Widerstand aufweisen, und bei der der elektrische Widerstand der Regelmittel gleich dem elektrischen Widerstand der zweiten mechanischen Verbindungsmittel (14) ist, derart, dass der thermopiezoresistive Effekt kompensiert wird.

**7.** Mikroelektronische Resonanzstruktur nach einem der Ansprüche 2 bis 6, bei der die Stromregelmittel wenigstens einen Dipol (28) umfassen, der in Reihe mit den zweiten mechanischen Verbindungsmitteln (14) verbunden ist, wobei der Dipol eine negative Widerstandscharakteristik in der Nähe des Arbeitspunkts der mikroelektronischen Resonanzstruktur hat.

**8.** Mikroelektronische Resonanzstruktur nach Anspruch 7, bei der der Dipol (28) ausgewählt ist aus einer Tunneldiode, einer Gunn-Diode, einem Thyristor und einem Rückkopplungskreis, der wenigstens einen Operationsverstärker umfasst.

**9.** Mikroelektronische Resonanzstruktur nach einem der Ansprüche 2 bis 8, bei der die Stromregelmittel wenigstens eine Induktivität umfassen, die in Reihe mit den zweiten mechanischen Verbindungsmitteln verbunden ist.

**10.** Mikroelektronische Resonanzstruktur nach einem der Ansprüche 2 bis 9, umfassend Mittel zur aktiven Steuerung der Polarisationsspannung, die es ermöglichen, eine konstante Spannung an die zweiten mechanischen Verbindungsmittel anzulegen.

**11.** Mikroelektronische Resonanzstruktur nach Anspruch 10, bei der die Mittel zur aktiven Steuerung der Polarisationsspannung eine Spannungsrückkopplungsschleife (CR) umfassen, die Mittel (21) zur Messung der Spannung an den Anschlüssen der zweiten mechanischen Verbindungsmittel umfasst, beispielsweise mittels einer Vierdrahtmethode, einen Komparator (22) zum Vergleichen der gemessenen Spannung und einer Sollspannung, und ein Korrekturelement (26), das ein Korrektursignal an die Polarisationsmittel schickt.

**12.** Mikroelektronische Resonanzstruktur nach einem der Ansprüche 1 bis 11, bei der die zweiten mechanischen Verbindungsmittel (14) einen Balken (18) umfassen.

**13.** Mikroelektronische Resonanzstruktur nach einem der Ansprüche 1 bis 12, bei der das erste mechanische Element ein Verankerungspunkt ist, der mit einem Träger verbunden ist, und die bewegliche Masse (2) drehbar bezüglich des Verankerungspunkts angelenkt ist, und bei der das zweite mechanische Element (24) ein zweiter Verankerungspunkt ist, der mit dem Träger verbunden ist.

**Claims**

**1.** A resonating microelectronic structure comprising at least one movable mass (2) mechanically connected to at least one first mechanical element by first mechanical connection means (6) and to at least one second mechanical element by second electrically conductive mechanical connection means (14), said mass being configured to be vibrated by an external stimulus, electrical bias means (15) for electrically biasing the second mechanical connection means (14), said second mechanical connection means (14) being such that they are the object of a thermo-piezoresistive effect, the second connection means (14) and the movable mass (2) being disposed with respect to each other such that a movement of the movable mass (2) applies a mechanical stress to the second connection means (14), wherein the electrical bias means (15) form with at least the second mechanical connection means (14) a thermo-piezoresistive feedback electric circuit, **characterized in that** the electrical bias means (15) are DC voltage bias means.

2. The resonating microelectronic structure according to claim 1, wherein the thermo-piezoresistive feedback electric circuit comprises current regulation means electrically connected in series with the second mechanical connection means.

3. The resonating microelectronic structure according to claim 2, wherein the current regulation means comprise at least one electrical component (Rc) able to assume a determined electrical resistance value.

4. The resonating microelectronic structure according to claim 3, wherein the electrical component (Rc) is such that it enables a determined electrical resistance value to be selected from several electrical resistance values, the electrical element being advantageously a potentiometer.

5. The resonating microelectronic structure according to claim 3 or 4, wherein the second mechanical connection means (14) have a given electrical resistance and wherein the electrical resistance of the regulation means has a value lower than or equal to 5 times the electrical resistance value of the second mechanical connection means (14) when the movable mass (2) is in the idle state.

6. The resonating microelectronic structure according to claim 3 or 4, wherein the second mechanical connection means (14) have a given electrical resistance and wherein the electrical resistance of the regulation means is equal to the electrical resistance of the second mechanical connection means (14) so as to compensate for the thermo-piezoresistive effect.

7. The resonating microelectronic structure according to one of claims 2 to 6, wherein the current regulation means comprise at least one dipole (28) connected in series with the second mechanical connection means (14), said dipole having a negative resistance characteristic in the vicinity of the operating point of the resonating microelectronic structure.

8. The resonating microelectronic structure according to claim 7, wherein the dipole (28) is chosen from a tunnel diode, a Gunn diode, a thyristor and a feedback circuit comprising at least one operational amplifier.

9. The resonating microelectronic structure according to one of claims 2 to 8, wherein the current regulation means comprise at least one inductor connected in series with the second mechanical connection means.

10. The resonating microelectronic structure according to one of claims 2 to 9, comprising active control means for actively controlling the bias voltage enabling a constant voltage to be applied to the second mechanical connection means.

11. The resonating microelectronic structure according to claim 10, wherein the active control means for actively controlling the bias voltage comprise a voltage feedback loop (CR) comprising measurement means (21) for measuring the voltage at the terminals of the second mechanical connection means, for example by a 4-wire method, a comparator (22) for comparing said measured voltage and a reference voltage, and a corrector (26) sending a corrective signal to the bias means.

12. The resonating microelectronic structure according to one of claims 1 to 11, wherein the second mechanical connection means (14) comprise a beam (18).

13. The resonating microelectronic structure according to one of claims 1 to 12, wherein the first mechanical element is an anchoring pad secured to a support and the movable mass (2) is rotatably hinged with respect to the anchoring pad and wherein the second mechanical element (24) is a second anchoring pad secured to the support.

FIG.1

FIG.2

$R_c$  $R_{par1}$  $R_{p0} + \Delta R_p$  $R_{par2}$

15

$V_c$

I

FIG.3

15

$R_c$  $R_{p0} + \Delta R_p$

$V_c$

I

FIG.4

$V_{consigne}$

26

22

CR

21

$V_s$

15

$R_c$  $R_{par1}$  $R_{p0} + \Delta R_p$  $R_{par2}$

$V_c$

I

FIG.5

FIG.6

FIG.7

FIG.8A

FIG.8B

FIG.8C

FIG.8D

FIG.8E

FIG.8F

FIG.9A

FIG.9B

FIG.9C

**FIG.10**

**FIG.11**

# EP 3 558 862 B1

## RÉFÉRENCES CITÉES DANS LA DESCRIPTION

*Cette liste de références citées par le demandeur vise uniquement à aider le lecteur et ne fait pas partie du document de brevet européen. Même si le plus grand soin a été accordé à sa conception, des erreurs ou des omissions ne peuvent être exclues et l'OEB décline toute responsabilité à cet égard.*

**Littérature non-brevet citée dans la description**

- **LEHEE G ; SOUCHON F ; RIOU JC ; BOSSE-BOEUF A ; JOURDAN G.** Low power damping control of a resonant sensor using back action in silicon nanowires. *2016 IEEE 29th International Conference on Micro Electro Mechanical Systems (MEMS),* 2016, 99-102

- **STEENEKEN PG ; LE PHAN K ; GOOSSENS MJ ; KOOPS GEJ ; BROM GJ A. M ; VAN DER AVOORT C et al.** Piezoresistive heat engine and refrigerator. *Nat Phys.,* Avril 2011, vol. 7 (4), 354-9